# EUROPEAN PATENT APPLICATION

(11) **EP 0 848 296 A1**
(43) Date of publication of application: **17.06.1998**
(21) Application number: 97203899.6
(22) Date of filing: 12.12.1997
(51) Int. Cl.: G03F 7/095, G03F 1/00, G03F 1/10, G03F 1/12

(54) **System and method for providing photographic printing plates and the like**

(30) Priority: 12.12.1996 NL 1004757
(71) Applicant: A.V. FLEXOLOGIC B.V., NL-2408 AW Alphen A/D Rijn (NL)
(72) Inventor: Van Der Horst, Hans, 2465 AR Rijnsaterwoude (NL)
(74) Representative: Duxbury, Stephen

(57) **Abstract**

The present invention relates to a system for providing image and/or text carriers which serve as printing and/or lithographic plates, photographic prints, microfilm copies and the like, wherein the system comprises:
- a carrier having a radiation-sensitive layer, which radiation-sensitive layer has a composition such that after irradiation it is substantially impermeable to developer liquid.

## Description

This invention relates to a system and method for providing printing and/or lithographic plates, photographic prints, microfilm copies and the like.

The production of flexographic printing plates currently takes place, among others, in the following manner.

Firstly, the image for printing is read into a computer. The image is herein digitized and provided with a raster, and colour separation takes place. A negative film is made of each colour for which a printing plate is manufactured. This film 2 is subsequently tensioned by means of contact pressure onto a photopolymeric carrier 4 which has been coated with a mask layer 6 (see figure 1a).

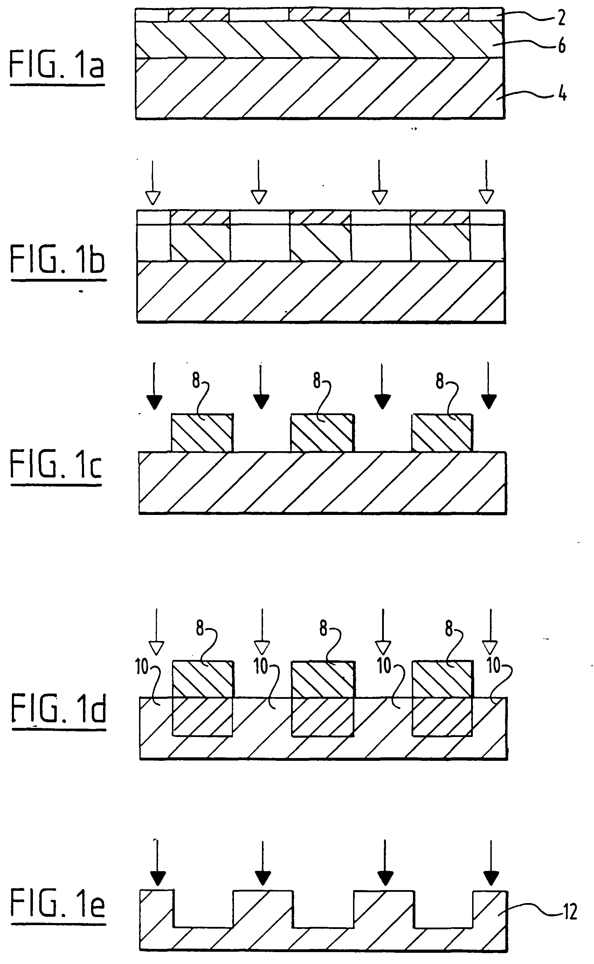

Through the negative film 2 the mask layer 6 is exposed to UV light (figure 1b) and subsequently developed with a liquid (figure 1c), wherein the exposed mask layer does not colour black while the non-exposed mask layer 8 does so. The resulting pattern is a mask for the underlying photo carrier which is to be exposed. The top side of the photopolymer is subsequently exposed, wherein the exposed portions 10 hereof become resistant to solvent (hardening).

The mask layer as well as the non-exposed portions of the photopolymer are then washed out (figure 1e), wherein the flexoprinting plate 12 is ready for use.

A lack of accuracy in this known process results in damage to the desired image. The making of a negative film, applying thereof to a carrier and the mechanical removal of this negative film during the development of the flexographic printing plate further requires much time and mechanical precision and entails high costs.

An object of the present invention is to provide an improved system for providing flexographic printing plates and the like.

In accordance with a first aspect, the present invention provides a system for providing image and/or text carriers which serve as printing and/or lithographic plates, photographic prints, microfilm copies and the like, wherein the system comprises:
- a carrier having a radiation-sensitive layer, which radiation-sensitive layer has a composition such that after irradiation it is substantially impermeable to developer liquid.

Replacement of a negative film by this radiation-sensitive layer, which becomes a selective developer liquid barrier layer when it is irradiated, considerably shortens the production time for providing a flexographic printing plate, for instance to about 20 minutes instead of hours, whereby more printing plates per unit of time can be made and whereby a considerable energy saving is achieved of for instance a factor of five.

The radiation-sensitive layer becomes insoluble in a developer liquid when irradiated. In the selective exposure of the radiation-sensitive layer to radiation, predetermined locations thereon become impermeable to developer liquid, wherein a selective developer liquid barrier is formed.

In preference the system further comprises a mask layer for the carrier, which non-radiated mask layer has a composition such that after treatment with a developer liquid it is substantially impermeable to radiation, i.e. if the mask layer is irradiated prior to exposure to a developer liquid, the mask layer does not react with the developer liquid in order to form a radiation-impermeable medium. The irradiated mask layer locations therefore remain permeable to radiation.

The non-radiated locations on the radiation-sensitive layer dissolve in developer liquid so that the underlying mask layer reacts at these locations with the developer liquid, whereby it becomes impermeable to radiation.

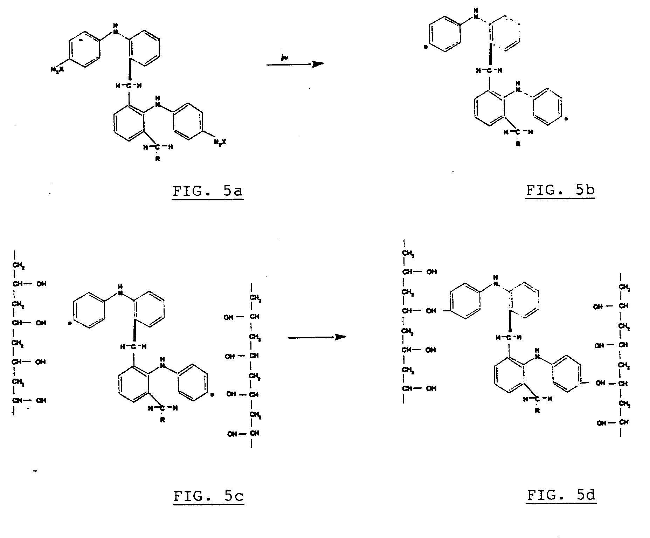

The radiation-sensitive layer can comprise a diazopolymer preferably comprising the following diazomonomer units: 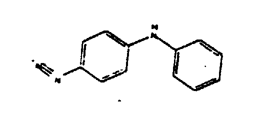 and which is most preferably the condensation product of paraformaldehyde diazo-1-phenylamino-4-benzene and zinc chloride, referred to hereinbelow as BU-12 (figure 5a).

When exposed (figure 5b), the charged nitrogen compounds of the diazopolymer are disassociated, wherein the ionogenic properties of the compound disappear so that the polymer is no longer soluble in a developer liquid.

Most preferably, the diazo-polymer is irradiated in the presence of a polymer backbone forming agent, for example polyvinylalcohol, whereby the diazo-free radicals react with hydroxy groups from the PVA chains in order to form crosslinks between such chains (see figure 5c). In this situation the diazopolymer has a bridge function to yield the radiation sensitive layer (figure 5d).

The above reaction can also be carried by using photo-initiators, whereby, subsequent to irradiation, free radicals are formed, which have an initiating working on the formation of polymer chains.

Other preferred backbone forming agents include acrylic systems, epoxy-resins, acrylic amides, styrene, phtiolene and compounds with olefinic double bonds and vinylethers.

The use of photo-initiators in order to initiate the radical reaction, provides the possibility to vary the wavelength at which the top layer is irradiated since in this case the requirements of the laser are not so strict.

Preferably the diazo compound has two or more diazo-groups, i.e. a double nitrogen bond so that two free radicals are available for bridge forming (see the above and figure 5c).

Preferably the backbone forming agent is reacted with the diazo-polymer in the form of an emulsion. The inventors have shown that an emulsion is significantly more effective than a solution.

Apart from the possibility of forming diazonium salt radicals, as above, it is also possible to form diazonium salt cations whereby polymer structures can be formed in the presence of epoxy resins.

Accordingly, it is possible to use epoxy resins in the presence of photo-initiators in order to provide diazo polymer chains, yielded by means of cation reactions. Such a reaction is initiated by forming a cation, or a strong electrophile such as a Lewis acid or a protonic Bronsted acid.

A very sensitive layer is thus provided, wherein an image can be arranged directly onto the carrier in very accurate manner.

The mask layer preferably comprises diazo compounds which are most preferably chosen from the group consisting of:
- Diazo-1((ethoxy)carbonyl)(methyl)amino-2-methoxy-5-((methyl-4')phenyl)thio-4-benzene-HSO₄*3H₂O, referred to hereinbelow as D95, and
- Diazo-1-dibutoxy-2-5-(methoxy-4')phenyl-4-benzene-Cl, referred to hereinbelow as D71.

The diazo compounds of the mask layer preferably comprise at the most one nitrogen bond per monomer in order to prevent polymerization occurring.

When a mask layer is applied, a very precise relief/image can be obtained in the underlying carrier.

The carrier preferably comprises a radiation-sensitive material which when irradiated becomes insoluble in a solvent. This radiation-sensitive material can comprise monomer units which during the exposure transform (harden) into polymer compounds by means of cross-linking and chain extension. A relief can thus be obtained on this carrier plate by irradiating determined locations and not irradiating others. At the locations which-are not irradiated the monomeric compound can be washed off with a solvent in order to obtain the final flexographic printing plate. The carrier can comprise for instance a rubber or thermoplastic elastomer.

In order to achieve a good image formation quickly, radiation preferably takes place with an UV laser.

A further problem in the use of film negatives is the occurrence of air bubbles thereunder, which has an adverse effect on the final image quality of the printing plate. Air bubbles are created due to the heat released during development of a printing plate according to the known method (figure 1). Since substantially no heat is released with the use of UV radiation, this problem is substantially avoided.

The developer liquid can be any suitable developer liquid, for instance the sodium salt of 2,3 dihydrooxynaphthalene-6-sulphonic acid.

An isolating layer can be arranged between the carrier and the mask layer and/or between the mask layer and the radiation-sensitive layer in order to isolate the layers from each other. The isolating layer preferably comprises trichloroethane, iso-propanol, trichlorotrifluoroethane fluoropolymer.

According to another aspect of the present invention a method is provided for providing printing plates and the like, comprising of:
- selectively exposing the above stated system to radiation, preferably UV radiation, followed by
- developing the system with a developer liquid, and
- exposing the thus developed system to radiation.

According to yet another aspect of the present invention a diazopolymer is provided which is obtainable by means of the condensation reaction between diazo-1-phenylamino-4-benzene and zinc chloride.

The present invention will now be elucidated on the basis of the following description with reference to the annexed figures, in which:
figures 1a-1e show a stepwise diagram for providing a flexographic printing plate according to a known method,
figures 2a-2e show a stepwise first diagram for providing a flexographic printing plate according to the present invention,
figure 3 shows a reactions mechanism for making a radiation-sensitive layer polymer, according to the present invention,
figure 4 shows the UV adsorption spectrum of the radiation-sensitive layer obtainable according to the mechanism shown in figure 4, before (v) and after (n) UV exposure,
figure 5a shows the diazopolymer component of the radiation sensitive layer,
figure 5b shows a mechanism for forming radicals on the polymer from figure 5a,
figure 5c shows the mechanism of the reaction of the radical polymer from figure 5b with PVA backbones, and
figure 5d shows the resulting PVA-diazo, radiation sensitive layer.

A known system for providing flexographic printing plates consists of a negative film 2, a mask layer 4 and a photopolymeric carrier 6 (see figure 1 and introduction).

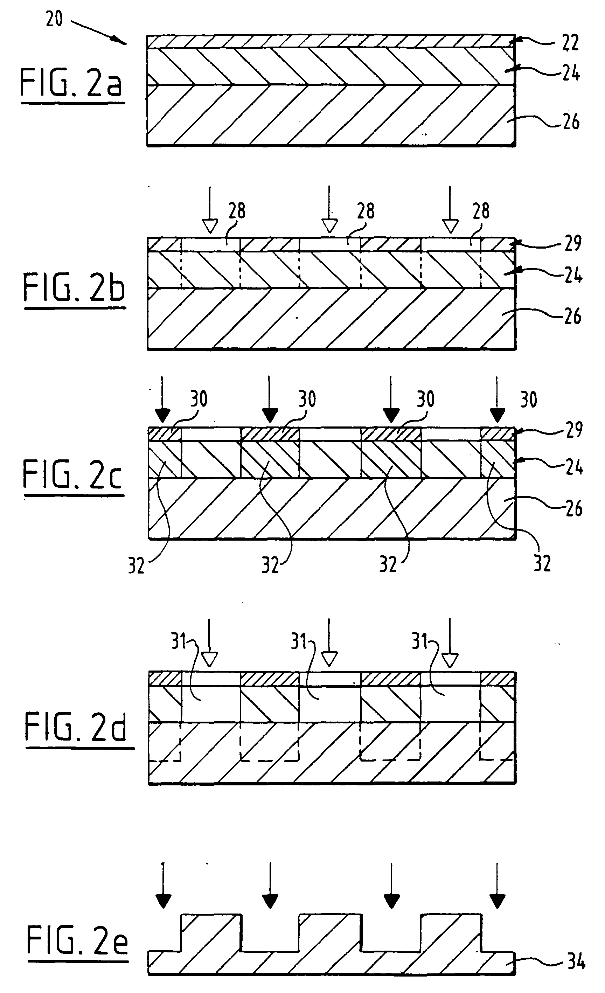

A system 20 according to the present invention (figure 2a) comprises a radiation-sensitive diazopolymer layer 22, a diazo compound layer 24 and a carrier 26.

The carrier 26 is preferably a commercially available photopolymer.

An isolation layer (not shown) can be provided on the carrier 26 in order to isolate the layers thereon from the solvents present in the photopolymer. An example of this isolation layer is polyvinylalcohol in combination with glyoxal or Mowital™ from Hoechst.

The diazo compound layer 24 is a diazo from Stork having the tradename SG142 photo-solution, which is preferably mixed with the binder B30H Mowital™ from Hoechst in order to provide a good development rate.

Between the diazopolymer layer 22 and the diazo compound layer 24, a bonding layer (not shown) can be applied in order to prevent the photopolymer layer 26 from sticking to the diazo compound layer on irradiation. A preferred bonding agent is DETAC™ or DETACL™.

In order to write a relief (image) directly onto carrier 26 the diazopolymer layer 22 is first irradiated with UV light (figure 2b), whereby these exposed locations 28 become insoluble in a developer liquid.

In this manner a selective barrier is created for the developer liquid.

There are then two options for image formation on the photopolymeric carrier, positive or negative writing.

In positive writing (figures 2c-2e), a developing step is then used (figure 2c), wherein the portions 32 of the diazo compound layer 24 under the non-irradiated portions 30 of diazopolymer layer 22 react with the developer liquid.

The carrier 26 is subsequently irradiated (figure 2d). The non-irradiated barrier layer parts 26 are then washed out with the mask layer 31 in order to provide the relief 34.

In negative writing (not shown) flushing with a developer liquid first takes place after writing with a laser. The non-irradiated diazopolymer layer is herein washed away with the non-irradiated diazo compound mask layer. The remaining diazo compound mask layer is subsequently developed, if necessary after removal of the diazopolymer layer. The photopolymer is then exposed.

The inventors have manufactured a flexographic printing plate as follows.

### Experimentally:

### Example 1

By means of rod-coating, a known method for applying layers, a BU-12 layer was applied to a diazo compound layer serving as the mask layer and having the form of a foil comprising both D95 and D71. The BU-12 solution was sprayed in front of the rod using a pipette, wherein the foil was pulled through beneath the rod and a quantity of BU-12 solution remained behind on the foil. Mounted directly behind the rod was a hot air fan heater which was able to dry the applied layer directly behind the rod. The BU-12 solution had a concentration of 20 gram BU-12 paste per litre of solvent. The solvent for the BU-12 was water, ethanol and acetone in the ratio of 2:1:1 respectively.

In addition to the use of rod-coating, roller coating was also applied as coating technique. In order to obtain a good optical density of the black pattern a diazo quantity of 3.7 gram diazo/m² is required; for the experiments a quantity of 0.7 gram diazo/m² was therefore used to enable demonstration of the effect of the principle.

The BU-12 solution was herein picked up from a basin by means of a roller, whereafter a roller lying thereon picks up a controlled quantity of liquid and the foil is then pulled between the second roller and a pressure roller, wherein the second roller applies the top layer onto the foil. The top layer is dried immediately after being applied.

### Exposure

The system was subsequently exposed with UV light having a maximum light intensity at a wavelength of 360 nm. The exposure time with a UV lamp of 8 Watts was roughly 30 seconds. Complete exposure of the diazo layer of the foils used took 5 minutes under these conditions.

### Developing

After exposure the foil was pulled for 5 seconds through a developing tray and the image became visible after a few seconds. The image in this case was black with a diazo-yellow background. Immediately hereafter the foil was exposed, wherein the layer was also dried by the heat development in the lamp. The finally resulting image was black with a transparent background.

### Result

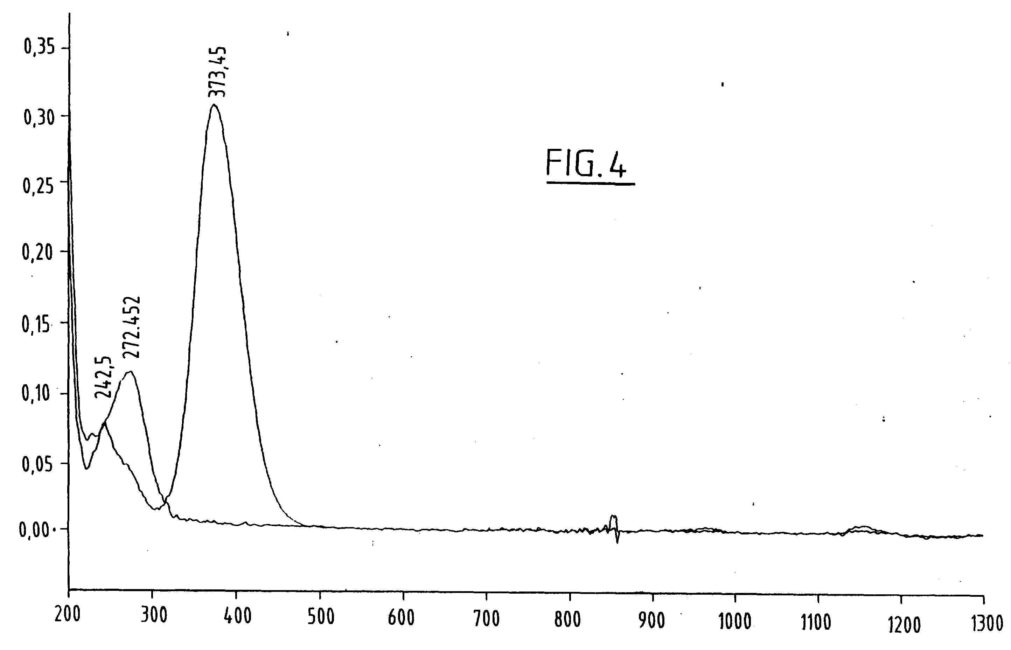

The best image formation was obtained with the use of D95-diazotype and roller coating as coating technique. In order to test the exposure time, calculations were made for two standard lasers. As reference was used the UV lamp used in the exposure experiments. An even exposure of a surface is assumed in the calculation of the writing time. The calculated power for writing of the BU-12 with the UV lamp used with a wavelength of 360 nm for an exposure time of 30 seconds was 112.5E-4 joule/cm². The sensitivity is determined on the basis of the UV adsorption spectrum of figure 4.

| Type laser | Ion laser (Coherent) | DPSS (LiCoNiX) |
|---|---|---|
| Power | 30 mWatt | 600 mWatt |
| Beam diameter | 2.0 mm | 1.5 mm |
| Wavelength | 442 nm | 354.7 nm |
| Sensitivity rel. to reference | 1/8 | 1/1.2 |
| Required exposure time/spot | 0.094 s | 0.00040 s |
| Required exposure time/A4 | 1395 s | 10.50 s |

It is noted that the total writing time will be a factor of 5 lower than now indicated, since writing is only required where image must appear. In order to achieve the correct resolution with the laser, a spot size must be created by means of lenses which complies with the desired resolution of the image. The spot size of the lasers can be changed by lenses. It is anticipated that the final exposure time for BU-12 with the correct choice of laser will be in the order of 1 minute/m².

### Example 2

A diazo layer as in example 1, was sprayed onto a photopolymer foil, this diazo layer consisted of a mixture of 4 grams of diazo (D95 and D71) mixed with 20 ml of ethanol and 20 ml 20% polyvinylbutyral binder. A thin layer of 20% solution polyvinylpyrrolidone in ethanol was sprayed subsequently thereon. On top of these two layers, a mixture of diazopolymer (BU12) and PVA emulsion was arranged by means of rod coating.

The radiation sensitive top layer consisted of a drop of diazopolymer solution (2.5 g a day of polymer per 20 ml of water), mixed with 5 g of PVA emulsion. This mixture was arranged on the diazo-layer by means of rod coating. The resulting system was subsequently irradiated with UV light, whereby the non exposed parts coloured black after developing with the aqueous developing medium. The radiated parts did not colour black on development.

### Preparation of BU-12

### Synthesis

### Chemicals required:

Variamine Bleu RT salt
Paraformaldehyde
ZnCl₂
NaCl (kitchen salt)
Sulphuric acid concentrated
Hydrochloric acid concentrated

### Method

56 ml concentrated sulphuric acid was placed in a test tube of 250 ml. The test tube was situated in a salt/ice bath of -10°C. The solution was stirred slowly with a top agitator. 20 grams variamine Bleu RT salt was added stepwise wherein the temperature of the liquid remained under 5°C. 2.6085 grams paraformaldehyde was then added slowly in stepwise manner, spread over a period of about 2 hours.

After one hour of further stirring the liquid was placed in the refrigerator at a temperature of 0°C for a period of seven whole days. The content was subsequently poured out onto 800 ml ice water, stirred and the residue filtered off. During filtration the residue became black. The residue was dissolved in 50 ml lukewarm water and after dissolving this was supplemented to 300 ml water with a little ice therein while being stirred. 4 ml concentrated hydrochloric acid was added and 32 ml ZnCl₂ (50% solution) was added in drops, followed by 22 grams kitchen salt in stepwise manner (while stirring). The residue was filtered off and dried for a number of days in the excicator on concentrated sulphuric acid until it became a paste.

The solvent for the BU-12 is preferably made of water, ethanol and acetone in the ratio of 2:1:1 respectively. Water serves to dissolve the BU-12; the ethanol serves to wetten the surface and thereby provide a good adhesion with the mask layer. The acetone is added to maintain a high speed of evaporation.

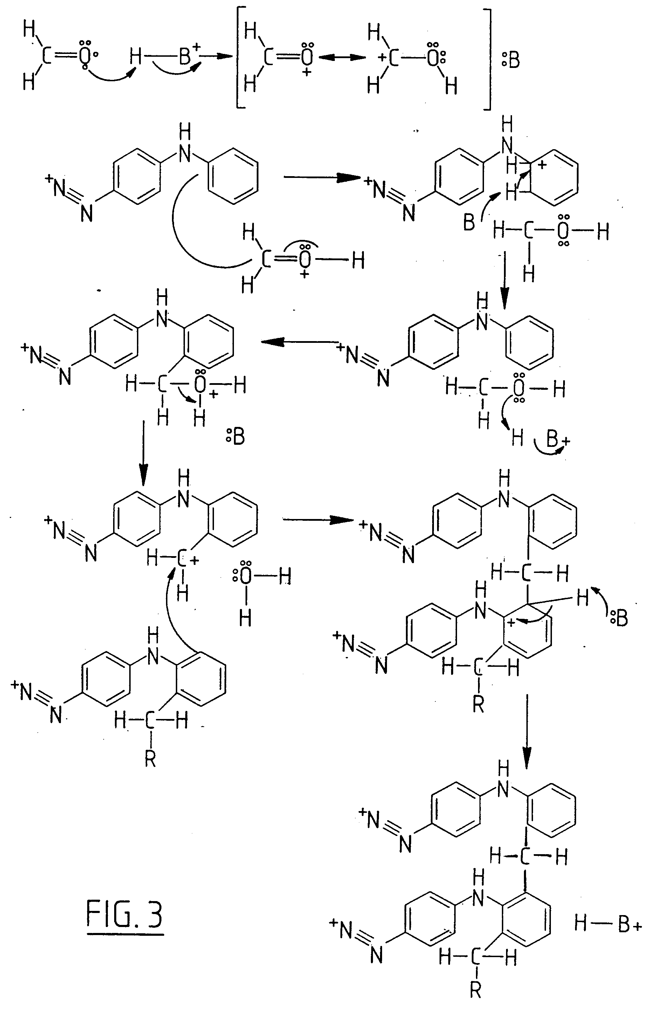

Figure 4 shows the UV adsorption spectrum of the radiation-sensitive layer obtainable in accordance with the mechanism of figure 3, before and after UV exposure.

### Alternative synthesis route with viscosimeter

An alternative method of preparation is to change the ratios of the chemicals. The reaction must then be stopped at the correct moment by adding water. Two practical examples follow here, wherein use is made of a cryostat at an adjustment temperature of -4°C:
1) 10 gram Variamine bleu RT salt was added to 31.25 ml concentrated sulphuric acid. In half an hour 1.8036 gram paraformaldehyde was added. After 53 hours the reaction could have been stopped, after 58 hours a rubbery polymer resulted.
2) 10 gram Variamine bleu RT salt was added to 31.25 ml concentrated sulphuric acid. In four hours 1.8038 gram paraformaldehyde was added. After 34 hours the reaction could have been stopped, after 36.5 hours a rubbery polymer resulted.
It can be inferred herefrom that the conditions are difficult to control. This is therefore the reason to perform the operation with a viscosimeter.

The invention is not limited to the above description, the requested rights are rather determined by the following claims.

## Claims

1. System for providing image and/or text carriers which serve as printing and/or lithographic plates, photographic prints, microfilm copies and the like, wherein the system comprises:
- a carrier having a radiation-sensitive layer, which radiation-sensitive layer has a composition such that after irradiation it is substantially impermeable to developer liquid.

2. System as claimed in claim 1, further comprising a mask layer for the carrier, which non-radiated mask layer has a composition such that after treatment with a developer liquid it is substantially impermeable to radiation.

3. System as claimed in any of the foregoing claims, wherein the radiation-sensitive layer comprises a diazopolymer.

4. System as claimed in claim 3, wherein the diazopolymer comprises the following diazomonomer units:

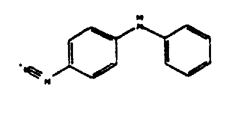

5. System as claimed in claim 3 or 4, wherein the diazopolymer is the condensation product of diazo-1-phenylamino-4-benzene and zinc chloride.

6. System as claimed in any of the preceding claims, wherein the radiation-sensitive layer has a composition such that after irradiation with UV radiation it is insoluble in developer liquid, preferably after irradiation by means of a laser with a wavelength of between 200 and 500 nanometre, for instance 310-470 nanometre, preferably 300-400 nanometre, and most preferably 373.5 nanometre.

7. System according to any of the preceding claims, wherein the radiation sensitive layer comprises a polymer backbone forming agent, preferably polyvinylalcohol, mixable with the layer in the form of an emulsion.

8. System as claimed in any of the preceding claims, wherein the mask layer comprises a diazo compound.

9. System as claimed in claim 8, wherein the diazo compound is chosen from the group consisting of:
- Diazo-1((ethoxy)carbonyl)(methyl)amino-2-methoxy-5-((methyl-4')phenyl)thio-4-benzene-HSO₄*3H₂O, Diazo-1-dibutoxy-2-5-(methoxy-4')phenyl-4-benzene-Cl.

10. System as claimed in any of the preceding claims, wherein the carrier is a radiation-sensitive material with a composition such that it hardens when irradiated.

11. System as claimed in claim 10, wherein the carrier comprises monomer units which when irradiated are transformed into a polymer layer.

12. System as claimed in any of the preceding claims, further comprising an isolating layer arranged between the carrier and the mask layer and/or between the mask layer and the radiation-sensitive layer.

13. Method for providing printing plates and the like, comprising of:
- selectively exposing the system as claimed in any of the preceding claims to UV radiation, followed by
- developing the system with a developer liquid, and
- exposing the thus developed system to radiation.

14. Method as claimed in claim 13, wherein the developed system is washed in a solvent.

15. Method as claimed in claim 11 or 12, comprising the step of washing the system with a solvent before developing the system.

16. The diazopolymer obtainable from the condensation reaction between paraformaldehyde diazo-1-phenylamino-4-benzene and zinc chloride.

17. Use of a polymer as claimed in any of the claims 4, 5 or 16 as a selective developer liquid barrier in a system for providing printing plates and the like.

18. Printing and/or lithographic plates, photographic prints, microfilm copies and the like obtainable with the method as claimed in any of the claims 13-15.

19. System for providing image and/or text carriers which serve as printing and/or lithographic plates, photographic prints, microfilm copies and the like, wherein the system comprises:
- a carrier to which is applied a layer, preferably a diazo compound layer, which layer has a composition such that after treatment with a developer liquid it is substantially impermeable to radiation.

20. Process for providing a system according to any of the claims 1-11, comprising the steps of:
- arranging a mask layer, preferably comprising a diazo compound according to claim 7, on a photo sensitive carrier,
- arranging a radiation sensitive layer on the mask layer, which radiation sensitive layer preferably comprising a diazopolymer according to claim 5, optionally mixed with a polyvinylalcohol emulsion.
